(19) Europäisches Patentamt
European Patent Office
Office européen des brevets

(11) EP 2 328 170 A1

(12) EUROPEAN PATENT APPLICATION

(43) Date of publication:
01.06.2011 Bulletin 2011/22

(51) Int Cl.:
H01L 21/266 (2006.01)
H01L 21/033 (2006.01)
H01L 31/107 (2006.01)
H01L 21/225 (2006.01)
H01L 31/0352 (2006.01)

(21) Application number: 10252000.4

(22) Date of filing: 24.11.2010

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 25.11.2009 US 626018

(71) Applicant: Sensors Unlimited, Inc.
Priceton, NJ 08540 (US)

(72) Inventors:
• Forsyth, Keith
Philadelphia, Pennsylvania 19128 (US)
• Clay, Noah
Lunenberg, Massachusetts 01462 (US)

(74) Representative: Bailey, Richard Alan
Marks & Clerk LLP
27 Imperial Square
Cheltenham
Gloucestershire GL50 1RQ (GB)

(54) Concentric ring mask for controlling the shape of a planar PN junction

(57) A mask for use in making a planar PN junction in a semiconductor device includes a central mask opening and a plurality of spaced apart concentric mask openings surrounding the central mask opening. The concentric mask openings each have a width less than a maximum dimension of the central mask opening. The central mask opening can be circular and the concentric mask openings can have a ring-shape. The mask can be used to form openings in a wafer layer for introducing an impurity to dope that wafer layer.

Fig. 1
(Prior Art)

**Description**

**CROSS REFERENCE TO RELATED APPLICATIONS**

None.

**BACKGROUND OF THE INVENTION**

**Field of the Invention**

The present invention is related to a method and apparatus for making a planar junction. In particular, it is directed to a method and apparatus that employs a concentric ring mask during a diffusion or ion implantation step in junction formation.

**Background**

In a typical dopant diffusion process for forming a PN junction in an avalanche photodiode (APD), the layer to be doped is covered with a diffusion mask having a central opening of predetermined shape and size. Dopant ions, which diffuse approximately isotropically, are then diffused through the opening of the mask into the layer to be doped. The action of a single narrow mask opening in controlling the diffusion depth was described by Kennedy & Murley in 1966 (DP Kennedy & PC Murley, Calculations of Impurity Atom Diffusion Through a Narrow Diffusion Mask Opening, IBM Journal, January 1966, pages 6 - 12).

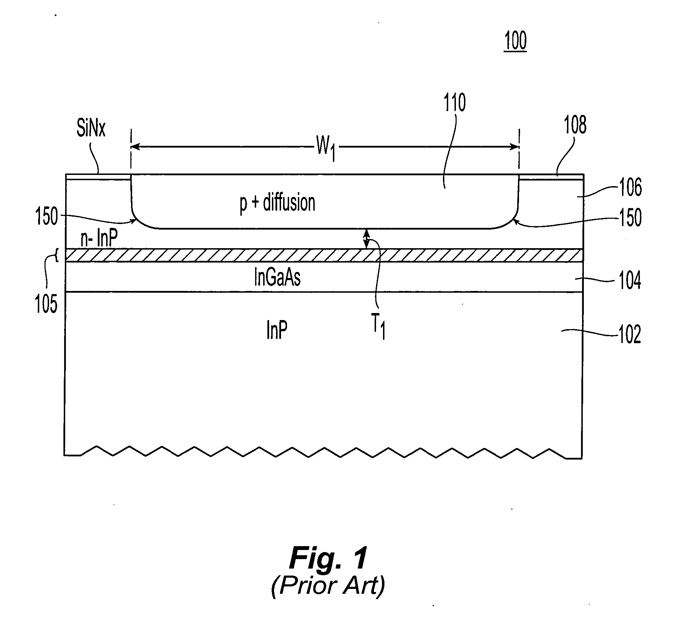

Fig. 1 shows a cross-sectional view of the upper layers of a prior art avalanche photodiode 100. The prior art photodiode is formed on a wafer comprising a plurality of layers. As seen in Fig. 1, among the various layers are a first InP buffer layer 102, a InGaAs absorber layer 104 on top of the InP layer, grading and charge layers shown collectively as layer 105 on top of the InGaAs absorber layer, and a lightly n-doped second InP layer 106 (which serves as the 'multiplication' layer) on top of the layer 105. An SiNx (e.g., silicon nitride) layer 108 is formed atop lightly n-doped InP layer 106, all in a known manner. The InGaAs absorber layer 104, the grading and charge layers 105, and the lightly n-doped second InP multiplication layer 106 together form the well-known SAGCM (Separate Absorption Grading Charge Multiplication) structure of the InGaAs/InP APD 100.

A p+ diffusion region 110 is formed in the lightly doped n-type InP layer 106. In a top or plan view, the p+ diffusion region 110 (such as formed by zinc diffusion into the lightly doped n-type InP) is circular, with a diameter of W1. A PN junction is formed in the space charge region between the p+ diffusion region 110 and the lightly doped n-type InP layer 106. The outer edge 150 of the p+ diffusion region 110 are somewhat rounded due to the doping process, which employs a mask with a single central opening. The lightly doped n-type InP layer has a minimum thickness T1 between a central portion of the p+ diffusion layer 110 and the InGaAs layer 104.

In two dimensions, the cross-sectional shape of the resulting diffusion front is the convolution of the mask's central opening with the circular arc defined by isotropic diffusion from a point source. At the edges of the diffused region this results in a cross-section of approximately circular shape, with radius of curvature approximately equal to the diffusion depth. When a reverse bias is applied to the resulting PN junction, this shape leads to a significantly higher depletion-region electric field at the junction edge than over most of the central portion of the junction, and therefore produces the undesirable edge breakdown effect. In some cases, this breakdown may be due to tunneling and in others to avalanche breakdown.

Thus, the three-dimensional shape of a PN junction formed by thermal diffusion of dopants in a semiconductor devices affects the reverse breakdown voltage of the junction. In many types of semiconductor devices, junction breakdown occurs at a voltage below that expected for an ideal device due to localized breakdown in regions of the junction where the equipotential surfaces have large curvatures (i.e. short radii of curvature), typically near the lateral edges of the junction, leading to an undesirable local increase in the electric field (gradient of the potential). This undesirable reduction of the junction breakdown voltage due to edge effects is commonly termed "edge breakdown".

The problem of edge breakdown in planar PN junctions operated at high electric fields has been known to those skilled in art since the early period of planar semiconductor device technology. It has particularly been pointed out that diffused abrupt junctions with small radius of curvature at the periphery have much lower breakdown voltages than either plane mesa junctions or graded planar junctions of the same depletion width. This difference can be shown to be a consequence of the sharp increase in electric field that occurs when the equipotential surfaces have strong curvature, and is a simple consequence of Poisson's equation applied to the geometry of the diffused planar junction, the diffused graded junction, and the plane mesa junction. The use of a linearly-graded, rather than an abrupt, PN junction also mitigates the edge breakdown effect. However, the dopant distribution control required to form a linearly graded junction is often difficult if not impossible to obtain within the constraints of a given device manufacturing process.

In the past, various "guard ring" and multiple-diffusion (e.g., "double diffusion") structures have been applied in both silicon and III-V device technology in order to mitigate the electric field spike associated with the short radius of curvature at the periphery of a diffused abrupt junction.

With regard to edge gain control in avalanche photodiodes (APDs) specifically, the most common approach to edge gain control used in commercial InGaAs/InP APDs manufactured in recent years is the double-diffused P region design with shallow floating guard rings. An example of this can be see in Liu et al., A Planar InP/GaAs Avalanche Photodiode with Floating Guard Ring and Double Diffused Junction", IEEE J. of Lightwave Tech., v.10 n.2, February, 1992, pp 182-193, whose contents are incorporated by reference.

However, several years of experience manufacturing such devices for the telecommunications market has indicated that such an approach is at best marginally effective at eliminating edge gain, and then only for the relatively modest linear gains of 5 to 8 that are typical for APDs used in telecommunication applications. Since edge gain becomes more severe as the avalanche gain increases, the double-diffused design is not effective at consistently eliminating edge gain when the device is biased for quasi-infinite gain, as in Geiger-mode photon-counting applications. Application of Poisson's equation to the geometry of the double-diffused design also shows the fundamental ineffectiveness of this approach, since for realistic geometries and doping profiles a computer model shows that neither the shallow first diffusion nor the shallow floating guard rings can significantly affect the curvature of the equipotential lines at the edge of the smaller second diffusion.

One prior art alternative to double diffusion with its guard rings has been to pre-etch a well-shaped structure of a predetermined thickness in the upper surface of the multiplication layer prior to diffusion. The well-shaped structure gives the resulting device a stepped appearance, in a cross-sectional view thereof. Such a stepped structure can be seen in Fig. 1 of Tarof et al., Planar InP-InGaAs Single-Growth Avalanche Photodiodes with No Guard Rings, IEEE Photonics Technology Letters, v.7, n.11 (November 1995), pp 1330-1132, whose contents are incorporated by reference.

A number of other alternatives to double diffusion with shallow floating guard rings have been proposed as solutions to the problem of edge gain. Most of these alternatives have one or more serious drawbacks, such as marginal effectiveness (e.g. deep diffused floating guard ring), manufacturing difficulty (e.g. charge sheet etching & epitaxial regrowth, deep diffused floating guard ring, graded junction fabricated by ion implantation, addition of "decoupling" layers to the APD structure, sloped-sidewall trench etch), decreased device reliability (e.g. mesa junctions), or the imposition of constraints on the absorption and multiplication layer thicknesses that are unacceptable for photon counting devices.

The problem of edge breakdown in planar PN junctions is analogous to the general electrostatics problem of breakdown between two finite-size parallel-plate conducting electrodes embedded in a dielectric, where the P region is analogous to one electrode, the N region is analogous to the other electrode, and the depletion region is analogous to the dielectric. The edge-breakdown problem for finite-size plates is a common one in high-voltage engineering and was first treated by Maxwell in the 19th century and later by Rogowski in the early 20th. They showed that the electric field could be held constant at all radial locations within the central portion of the electrode gap and made monotonically decreasing outside that gap by shaping the electrodes so as to gradually increase the plate spacing with increasing radial distance near the plate edges. The electrode shape required to produce this effect is known within the field of high-voltage engineering as the Rogowski profile.

**SUMMARY OF THE INVENTION**

In one aspect, the present invention is directed to a method of making a planar semiconductor PN junction device. The inventive method comprises providing a wafer comprising a plurality of layers, including a first doped layer having a first doping type formed above an underlying layer, and introducing an impurity of a second doping type into said first doped layer through a concentric ring mask having a central mask opening and a plurality of concentric mask openings surrounding the central mask opening, wherein widths of the concentric mask openings are smaller than a largest dimension of the central mask opening, such that that introduction of said impurity forms a PN junction in said first doped layer.

In another aspect, the present invention is directed to a semiconductor PN junction device having a dopant diffusion front comprising a central lower boundary surrounded by a lateral lower boundary. The device is fabricated by single-step thermal diffusion of a dopant through a concentric ring mask having a central mask opening and a plurality of concentric mask openings surrounding the central mask opening, wherein widths of the concentric mask openings are smaller than a largest dimension of the central mask opening.

**BRIEF DESCRIPTION OF THE DRAWINGS**

Figure 1 shows a PN-junction in a prior art avalanche photodiode.

Figure 2 shows a PN-junction in an avalanche photodiode made using a mask in accordance with the present invention.

Figure 3 shows a planar view of one embodiment of a mask in accordance with the present invention.

Figure 4 shows a cross-sectional view of one embodiment of a mask in accordance with the present invention overlying a region to be doped.

Figure 5 shows steps for designing and utilizing a mask in accordance with one embodiment of the present invention.

## DETAILED DESCRIPTION OF THE INVENTION

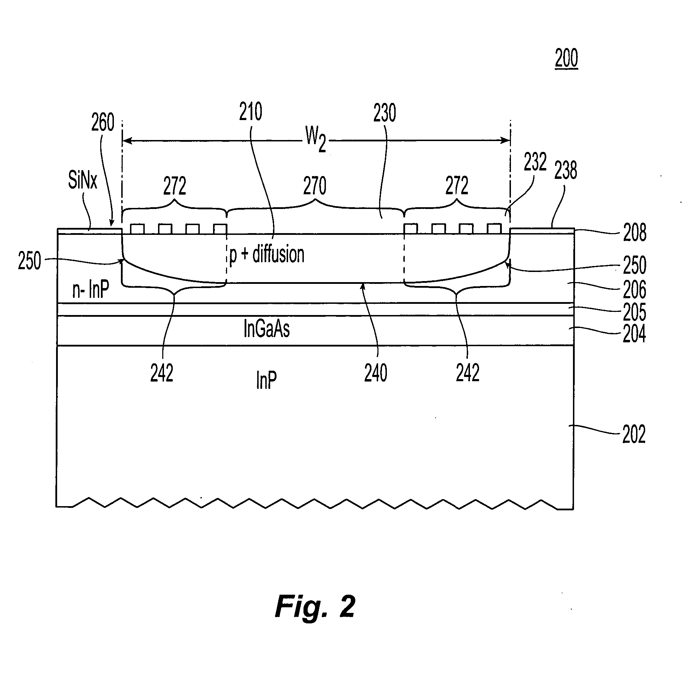

Fig. 2 shows a cross-sectional view of the upper layers of an avalanche photodiode 200 made in accordance with one embodiment of the present invention. The photodiode 200 includes a first InP buffer layer 202, a InGaAs absorber layer 204 on top of the first InP buffer layer 202, the charge and grading layers shown collectively as layer 205, and a lightly n-doped second InP layer 206 (which serves as the 'multiplication' layer) on top of the layer 205. An SiNx (e.g., silicon nitride) layer 208 is formed atop lightly n-doped InP layer 206. A p+ diffusion region 210 is formed in the lightly doped n-type InP layer 206.

In a top or plan view of the embodiment shown, the p+ diffusion region 210 is circular, with a diameter of W2. A PN junction is formed in the space charge region between the p+ diffusion region 210 and the lightly doped n-type InP layer 206. In a top view, the p+ diffusion region 210 comprises a substantially circular central portion 270 and a substantially annular lateral portion 272 surrounding the central portion 270.

In the cross-sectional view of Fig. 2, the central portion 270 of the p+ diffusion region has a central lower boundary 240 which is substantially flat and parallel to the upper surface 260 of the SiN layer 208, while the lateral portion 272 has a lateral lower boundary 242 that surrounds the central lower boundary 240 and is very slightly upwardly tapered from central lower boundary 240 to the rounded radially outer edge 250 of the p+ diffusion region 210. And since the diffusion region 210 is substantially circular in a top view, the lateral lower boundary 242 of p+ diffusion region 210 comprises a gradually tapered, approximately conical surface.

In a very general sense, in the cross-sectional view, a cross-sectional shape of the dopant diffusion front along the lateral lower boundary 242 has a continuously varying slope. In one embodiment, this slope is approximately zero at the edge of the central lower boundary 240 where it meets the lateral lower boundary 242 and increases monotonically as the rounded radially outer edge 250 is approached. Furthermore, in some embodiments, along the lateral lower boundary 242, the slope of the dopant diffusion front increases at a decreasing rate in the radially outward direction. In a given device, if the slope of the dopant diffusion front along the lateral lower boundary 242 increases too quickly in the radially outward direction, then edge breakdown may occur. If, on the other hand, the slope of the dopant diffusion front along the lateral lower boundary 242 increases too slowly in the radially outward direction, then the central lower boundary 240 will effectively be enlarged beyond what is desired.

One approximation for modeling the cross-sectional shape along the lateral lower boundary 242 in the device 200 of Fig. 2 may be given by:

$$d \doteq d0 + k\{1 - \cos[(r - r0)/s]\} \qquad \text{(Eq. 1)}$$

where:

r0 is a radius of the central lower boundary 240, i.e., the distance from a center of the central lower boundary 240 to an outer edge of the central lower boundary 240;

r is a radial coordinate relative to the center of the central lower boundary 240, over a finite range of r > r0;

d is the local width of the depletion region at radial coordinate r;

d0 is the width of the depletion region at r = r0; and

k and s are parameters which depend on the specific geometry, boundary conditions and carrier densities of the device, and can be determined by iterative solution of Poisson's equation, or the use of semiconductor device simulators such as SUPREM, all as known to those skilled in the art.

By scaling the parameters d0, r0, k and s, one may adapt the approximation to different sized device geometries and different semiconductor material systems, such that the resulting approximation of d is within 20% of the actual value of a given device for a finite range of r > r0. In one embodiment of an InP/InGaAs APD, the approximation of Eq. 1 may be valid for d0 = 0.5 $\mu$m, r0 = 25$\mu$m, 35$\mu$m > r > r0, 5 < k < 1.5 and 6 < s < 9.

The SiNx layer 208 forms the upper surface 260 of the device 200. In the embodiment of Fig. 2, the upper surface 260 includes a central upper surface portion 230 more or less directly above the central lower boundary 240, a lateral upper surface portion more or less directly about the lateral lower boundary 242, and an outer upper surface portion 238 overlying very little, if any, of the p+ diffusion region. Surface portions 230, 232 and 238 are substantially co-planar, unlike the pre-etched well regions with their stepped cross-section, as seen in Fig. 1 of above-mentioned Tarof paper.

When the device 200 is reverse-biased, the electric field will be concentrated within the unintentionally-doped N region. The two heavily doped regions (P and N respectively) will roughly approximate equipotential boundaries. As seen in Fig. 2, the P diffusion depth decreases gradually as the lateral edge 250 of the junction is approached. The approximately circular cross-sectional shape is still present at the outer edge 250 of the junction. However, contrasted with a conventionally-diffused junction, the diffusion depth beneath the ring mask edge is significantly shallower. As a consequence, the local depletion-region electric field remains below the breakdown field despite the short local radius of curvature at the edge. It is the larger depletion-region thickness at this point which prevents the electric field from being high enough to generate edge breakdown despite the steep junction curvature.

The outer edge 250 of a PN junction formed using a concentric ring mask in accordance with the present invention has a circular cross-sectional profile, much as in the case with using a conventional single diffusion mask opening.

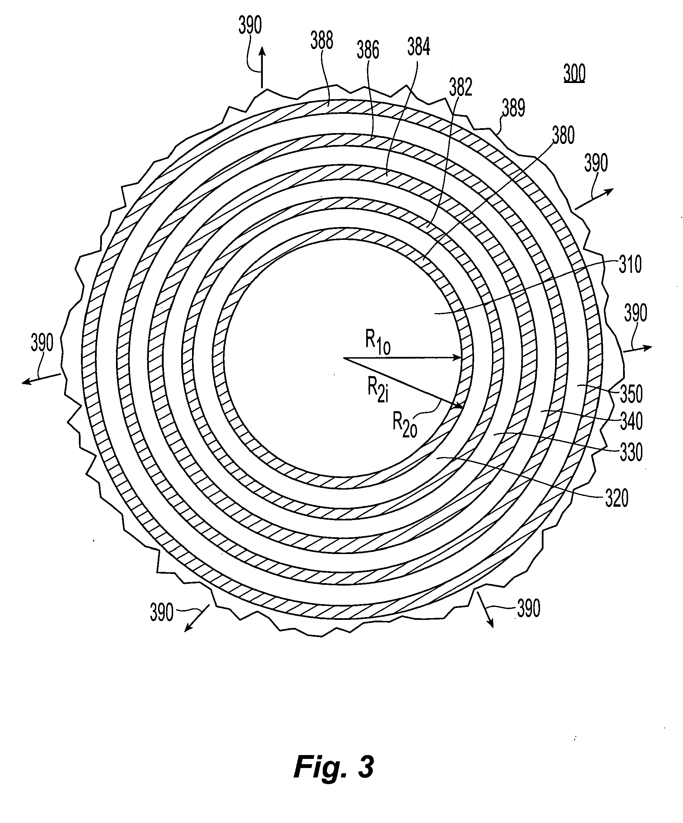

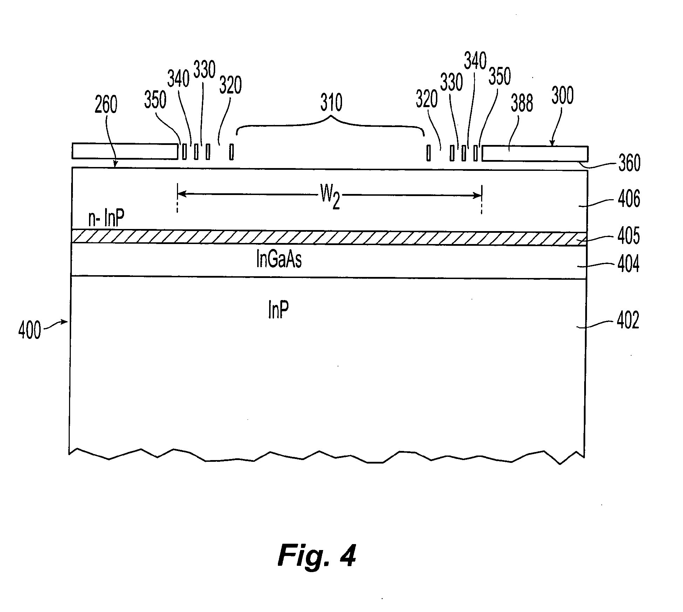

Fig. 3 shows one embodiment of a concentric ring mask 300 in accordance with the present invention. In contrast to a prior art diffusion mask having a single central opening, a concentric ring mask 300 in accordance with the present invention comprises a plurality of concentrically arranged optically opaque walls, shown generally by 380, 382, 384, 386 and 388. It is noted here that in Fig. 3, the outermost wall 388 is drawn as having a wavy outer border 389 with outwardly pointing arrows 390 to signify that the outer border 389 of outermost wall 388 extends to the outer extent of the mask 300, as seen in Fig. 4.

The walls 380, 382, 384, 386 and 388 define the boundaries of the central opening 310 and the concentric mask openings, shown generally by 320, 330, 340 and 350. The concentric mask openings 320, 330, 340 and 350 are smaller in width than the largest dimension (e.g., the diameter) of the central opening, and their width decreases with increasing radial distance. Thus, the concentric ring mask may be considered to comprise a central opening surrounded by a plurality of concentric ring-shaped openings of decreasing width, spaced apart from one another. Diffusion takes place through the various openings.

As also seen in Fig. 3, the central opening 310 has an outer radius Rlo and no inner radius. Each of the concentric mask openings 320, 330, 340, 350 has an inner radius and an outer radius which together define a width for that ring opening. Thus, for example, the first concentric mask opening 320 has an inner radius of R2i and an outer radius of R2o. In one embodiments the walls 380, 382, 384, 386 and 388 all have the same width, though this is not an absolute requirement.

Fig. 4 shows a cross-sectional view of the concentric ring mask 300 positioned above a wafer 400 used to form the device 200. The mask 300 is shown as floating above the wafer 400 for clarity; it is understood, however, that the mask 300 rests upon the wafer during a diffusion process. The wafer 400 comprises, from bottom upwards, a first InP layer 402, an InGaAs absorption layer 404, grading and charge layers, shown generally as 405, a lightly-doped n-type InP multiplier layer 406 and a SiNx layer 408. As seen in Fig. 4, the outer diameter of the largest ring 350 of the concentric ring mask 300 is approximately W2, which is the diameter of the p+ diffusion region 210 of the device 200 in Fig. 2.

If the diffusion depth is large compared to the width of each opening and to the spacing between adjacent openings, then diffusion through this concentric ring mask 300 results in a diffusion depth that decreases with increasing radial distance. In effect, the small concentric openings act to reduce the average dopant concentration at the surface that is the driving force of the diffusion process. By controlling the width and spacing of the openings, the local diffusion depth can be controlled over a wide range to produce the required gradual slope.

If the diffusion parameters of the materials system are known (e.g., the target dopant concentration vs. depth, perhaps following Eq. 1 and using Poisson's equation to find a junction profile that minimizes edge breakdown), then the specific ring mask pattern required to obtain a given junction profile can be quantitatively determined using semiconductor diffusion/implantation simulation software of the sort known to those skilled in art.

An effective ring mask pattern can also be determined using empirical experimental design techniques. One may initially guess at the correct ring mask pattern based on the general principles described herein, fabricate devices with that pattern and variations of it, test all of these devices and analyze the data to determine which ring mask patterns are more successful at suppressing edge breakdown. This procedure can then be iterated with new variations as many times as needed until a "good enough" solution is found..

Table 1 below shows an exemplary mask design specification for a circular, concentric ring mask in accordance with one embodiment of the present invention. In particular, Table 1 below provides the an empirically-determined mask design specification found to be effective in controlling edge breakdown in InGaAs/InP SAGCM APDs having a 50 micron diameter central diffusion opening. The mask design specification of Table 1 presents the inner and outer radii of each mask opening, and its width, with mask opening #1 corresponding to a central mask opening, and the remaining mask openings corresponding to the concentric mask openings.

Table 1 - Exemplary Concentric Ring Mask Specification

| Mask Opening # | Opening Inside Radius | Opening Outside Radius | Width of Opening (Radial) |
|---|---|---|---|
| 1 | 0 | 25.0 | 25.0 |
| 2 | 25.4 | 27.4 | 2.0 |
| 3 | 27.8 | 28.8 | 1.0 |
| 4 | 29.2 | 30.2 | 1.0 |
| 5 | 30.6 | 31.1 | 0.5 |
| 6 | 31.5 | 32.0 | 0.5 |
| 7 | 32.4 | 32.6 | 0.2 |
| 8 | 33.0 | 33.2 | 0.2 |

Table 1 above presents one embodiment of a mask pattern for use in a InGaAsP APD with Zn-diffused P regions. Which portions of the mask pattern are opaque and which are transparent is determined by the specifics of the lithography steps to be used to transfer the pattern, and particularly whether the photoresist to be used is positive or negative, as is known to those having ordinary skill in the art.

As seen in the concentric ring mask embodiment specified by Table 1, the width of the concentric mask openings are monotonically decreasing (or, alternatively, non-increasing) with increasing radial distance from a center of the central mask opening. Furthermore, widths of the concentric mask openings are not all the same size and so at least one concentric mask opening has width that differs in size from the remaining concentric mask openings. The increasingly narrow mask openings at increasing radial distance have the effect of reducing the effective diffusivity compared with the large central opening, and so produce a junction depth that is decreasing with radial distance in the concentric ring area. In the case of a junction which is approximately an abrupt one-sided junction (as would typically be the case for InGaAsP APDs), the resulting junction cross-section near the edges will correspond qualitatively to the Rogowski profile known in the field of high-voltage engineering.

As also seen in Table 1, the spacing between adjacent rings (and hence, the thickness of the walls between adjacent rings) in this embodiment is held constant, in this instance 0.4 microns. It is understood, however, that other wall thicknesses may likewise be used. Thus, in some embodiments, the inner diameter of one concentric mask opening may be more than 1 micron larger than an outer diameter of its adjacent, radially inward concentric mask opening, thus resulting in a wall thickness of 0.5 mm. Also, while concentric ring mask specified in Table 1 has a total of 8 openings, it is understood that masks with other numbers of openings may also be made.

It is further understood that those having ordinary skill in the formation of diffusion masks would know how to make a concentric ring mask, given the specifications of Table 1 and the material system used (e.g., Si, InGaAsP, InGaP, InGaN, etc.), the specific P dopant, the use of diffusion or ion implantation, process temperatures, and the like.

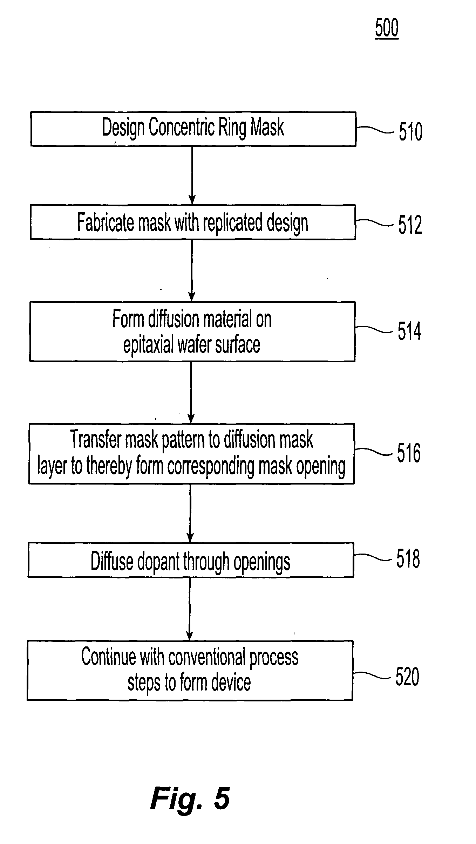

Fig. 5 shows a process flow diagram 500, illustrating one embodiment of the use process for forming a semiconductor device having a PN junction in accordance with the present invention.

In step 510, a concentric ring mask is designed. The concentric ring mask is provided with a series of narrow rings which surround a central large opening. The central large opening defines the primary active area of the device (e.g., an APD device). The width of the narrow rings should be monotonically decreasing or non-increasing with increasing radial distance. The specific number of rings and the specific numerical relationship between the radial distance and the inner and outer diameters of the openings depends on a number of details, as described above.

In step 512, a single mask having a plurality of the designed patterns is fabricated. Commercial mask fabrication vendors who can prepare such masks from standard designs are known in the relevant industry.

In step 514, a diffusion mask material, e.g., silicon nitride, is deposited on the epitaxial wafer surface. In the case of APD fabrication, the starting epitaxial wafer already incorporates the layer structure necessary to produce an APD: substrate, buffer, absorber, charge, bandgap grading, multiplication, and cap.

In step 516, using the mask and standard photolithographic and etching methods, the mask pattern is then transferred to the diffusion mask layer such that corresponding mask openings are produced.

In step 518, the P-dopant (e.g. Zn in InGaAsP) is diffused through the openings in a single step, to form the PN junction.

Finally, as seen in step 520, the method continues with the conventional process steps known to those skill in the art for producing the desired device, e.g., and APD.

Performing the above steps result in a device in which the electric field within a reverse-biased device will be constant across the active area, then gradually decrease with radial distance outside this area, such that when the lateral edge of the junction is reached, the geometry-induced increase in the electric field will be small enough to maintain a net field less than the field within the central active region. This eliminates the edge gain effect.

Thus, in the present invention, the shape of a diffusion front is controlled so as to produce an effect analogous to the Rogowski profile, despite the fact that dopant diffusion is approximately isotropic and its rate is fixed for a given materials system by the temperature and concentration gradient.

In the above-described embodiments, the central mask opening through which dopant ions are diffused is assumed to be circular. This circular central mask opening is surrounded by a plurality of radially outward ring-shaped openings having a variety of radial widths and spacings. The result is a generally radially and axially symmetric dopant concentration. It is understood, however, that other conventional central mask opening shapes, such as triangular, square, rectangular, or even other more complex geometries, may instead be used. When such non-circular central mask opening shapes are used, the corresponding mask openings will take on non-circular shapes.

In the above-described embodiments, diffusion is mentioned in process for an InGaAsP system, diffusion is mentioned. This is because diffusion is the most common junction formation method in the InGaAsP materials system. However, it is understood that in other materials systems, ion implantation could be used for junction formation, using the masks of the present invention.

The above-described single-step diffusion process can be used to manufacture devices in which it may be important to mitigate edge breakdown effects. Pertinent devices include, but are not limited to avalanche photodiodes (APDs) of the separate absorption grading charge and multiplication structure (SAGCM) fabricated in the InGaAsP materials system. Also, the process directly controls the three-dimensional shape of the PN junction in a manner that helps suppress edge breakdown in the final device. The diffusion method may thus employ fewer diffusion steps than the double diffusion approach, and can result in a less-variable manufacturing process.

While the present invention has been described herein above in connection with a plurality of aspects and embodiments, it is understood that these aspects and embodiments were presented by way of example with no intention of limiting the invention. Accordingly, the present invention should not be limited to any specific embodiment or aspect, but rather construed in breadth and broad scope in accordance with the recitation of the claims appended hereto.

**Claims**

1. A method of making a semiconductor PN junction device comprising:

   providing a wafer comprising a plurality of layers, including a first doped layer having a first doping type formed above an underlying layer; and
   introducing an impurity of a second doping type into said first doped layer through a concentric ring mask having a central mask opening and a plurality of concentric mask openings surrounding the central mask opening such that introduction of said impurity forms a PN junction in said first doped layer, wherein:

   widths of the concentric mask openings are smaller than a largest dimension of the central mask opening; and
   widths of the concentric mask openings are not all of the same size.

2. The method according to claim 1, wherein:

   the central mask opening is substantially circular;
   the concentric mask openings comprise substantially circular rings; and
   the concentric mask openings are of non-increasing width at increasing radial distance from a center of said central mask opening.

3. The method according to claim 2, wherein:

   the central mask opening is substantially circular;
   the concentric mask openings comprise substantially circular rings; and
   the concentric mask openings are of decreasing width at increasing radial distance from a center of said central mask opening.

4. The method according to claim 1, comprising:

   diffusing the impurity into the first doped layer.

5.  The method according to claim 4, wherein:

    an InGaAsP materials system is employed; and
    the impurity comprises zinc.

6.  A concentric ring mask suitable for diffusing an impurity into a doped layer, the concentric ring mask comprising a layer of material impervious to diffusion and having a plurality of openings formed therein, said plurality of openings including:

    a substantially circular central mask opening; and
    a plurality of concentric mask openings, each concentric mask opening comprising a substantially circular ring; wherein:

    widths of the concentric mask openings are smaller than a largest dimension of the central mask opening;
    widths of the concentric mask openings are not all of the same size; and
    the concentric mask openings are of non-increasing width at increasing radial distance from a center of said central mask opening.

7.  The concentric ring mask according to claim 6, wherein:

    the concentric mask openings are of decreasing width at increasing radial distance from a center of said central mask opening.

8.  The concentric ring mask according to claim 6, wherein:

    an inner diameter of a second concentric mask opening is more than 1 micron larger than an outer diameter of a radially inward first concentric mask opening.

9.  A semiconductor PN junction device having a dopant diffusion front comprising a central lower boundary surrounded by a lateral lower boundary, said device being fabricated by single-step thermal diffusion of a dopant through a concentric ring mask having a central mask opening and a plurality of concentric mask openings surrounding the central mask opening, wherein:

    widths of the concentric mask openings are smaller than a largest dimension of the central mask opening; and
    widths of the concentric mask openings are not all of the same size.

10. The semiconductor PN junction device according to claim 9, wherein the dopant is diffused through concentric mask openings whose widths do not increase with increasing radial distance from a center of said concentric mask.

11. The semiconductor PN junction device according to claim 9, wherein the dopant is diffused through concentric mask openings whose widths decrease with increasing radial distance from a center of said concentric mask.

12. The semiconductor PN junction device according to claim 9, wherein the dopant is diffused through a concentric ring mask in which an inner diameter of one concentric mask opening is more than 1 micron larger than an outer diameter of an adjacent, radially inward concentric mask opening.

13. The semiconductor PN junction device according to claim 9, wherein a cross-sectional shape of the dopant diffusion front along the lateral lower boundary has a continuously varying slope that is approximately zero at the edge of the central lower boundary where it meets the lateral lower boundary and increases monotonically as it reaches a radially outer boundary of the device.

14. The semiconductor PN junction device according to claim 9, wherein a cross-sectional shape of the dopant diffusion front along the lateral lower boundary has a slope that increases at a decreasing rate in a radially outward direction.

15. The semiconductor PN junction device according to claim 9, wherein a cross-sectional shape of the dopant diffusion front along the lateral lower boundary is within 20% of an approximation given by:

$$d = d0 + k\{1 - \cos[(r - r0)/s]\} \qquad\qquad \text{(Eq. 1)}$$

where:

r0 is the distance from a center of the central lower boundary to an outer edge of the central lower boundary;
r is a radial coordinate relative to the center of the central lower boundary, over a finite range of r > r0;
d is the local width of the depletion region at radial coordinate r;
d0 is the width of the depletion region at r = r0;
0.5 < k < 1.5; and
6.0 < s < 9.0.

**Fig. 1**
*(Prior Art)*

*Fig. 2*

**Fig. 3**

EP 2 328 170 A1

Fig. 4

13

<u>500</u>

```
┌─────────────────────────────────────┐
│      Design Concentric Ring Mask     │─── 510
└─────────────────────────────────────┘
                    │
                    ▼
┌─────────────────────────────────────┐
│   Fabricate mask with replicated design  │─── 512
└─────────────────────────────────────┘
                    │
                    ▼
┌─────────────────────────────────────┐
│        Form diffusion material on        │─── 514
│        epitaxial wafer surface           │
└─────────────────────────────────────┘
                    │
                    ▼
┌─────────────────────────────────────┐
│   Transfer mask pattern to diffusion mask   │─── 516
│ layer to thereby form corresponding mask opening │
└─────────────────────────────────────┘
                    │
                    ▼
┌─────────────────────────────────────┐
│      Diffuse dopant through openings      │─── 518
└─────────────────────────────────────┘
                    │
                    ▼
┌─────────────────────────────────────┐
│     Continue with conventional process    │
│          steps to form device             │─── 520
└─────────────────────────────────────┘
```

*Fig. 5*

Europäisches
Patentamt

European
Patent Office

Office européen
des brevets

## EUROPEAN SEARCH REPORT

Application Number

EP 10 25 2000

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/081874 A1 (FRANCIS DANIEL A [US] ET AL) 20 April 2006 (2006-04-20) * paragraph [0039] - paragraph [0044]; figures 1,6,7 * | 1-15 | INV. H01L21/266 H01L21/225 H01L21/033 H01L31/0352 H01L31/107 |
| A,D | LIU ET AL.: "A Planar InP/GaAs Avalanche Photodiode with Floating Guard Ring and Double Diffused Junction", IEEE J. OF LIGHTWAVE TECH., vol. 10, no. 2, 2 February 1992 (1992-02-02), pages 182-193, XP002625380, * page 183; figures 1,2 * | 1-15 | |
| A | US 2003/227028 A1 (BODEN MILTON J [US]) 11 December 2003 (2003-12-11) * paragraph [0016]; figures 1,2 * | 1-15 | |
| A | US 4 857 982 A (FORREST STEPHEN R [US]) 15 August 1989 (1989-08-15) * column 7, line 47 - line 54; figures 3,5,6 * | 1-15 | TECHNICAL FIELDS SEARCHED (IPC) H01L |
| A | US 2007/012948 A1 (DRIES J C [US] ET AL) 18 January 2007 (2007-01-18) * figures 1b, 2 * | 1-15 | |

The present search report has been drawn up for all claims

| Place of search | Date of completion of the search | Examiner |
|---|---|---|
| Munich | 1 March 2011 | Nesso, Stefano |

EPO FORM 1503 03.82 (P04C01)

**ANNEX TO THE EUROPEAN SEARCH REPORT
ON EUROPEAN PATENT APPLICATION NO.**

EP 10 25 2000

This annex lists the patent family members relating to the patent documents cited in the above-mentioned European search report.
The members are as contained in the European Patent Office EDP file on
The European Patent Office is in no way liable for these particulars which are merely given for the purpose of information.

01-03-2011

| Patent document cited in search report | | Publication date | Patent family member(s) | | Publication date |
|---|---|---|---|---|---|
| US 2006081874 | A1 | 20-04-2006 | US 2006084187 A1 | | 20-04-2006 |
| US 2003227028 | A1 | 11-12-2003 | NONE | | |
| US 4857982 | A | 15-08-1989 | CA 1289233 C | | 17-09-1991 |
| | | | EP 0350505 A1 | | 17-01-1990 |
| | | | JP 4505233 T | | 10-09-1992 |
| | | | WO 8906443 A1 | | 13-07-1989 |
| US 2007012948 | A1 | 18-01-2007 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **DP KENNEDY ; PC MURLEY.** Calculations of Impurity Atom Diffusion Through a Narrow Diffusion Mask Opening. *IBM Journal,* January 1966, 6-12
- **LIU et al.** A Planar InP/GaAs Avalanche Photodiode with Floating Guard Ring and Double Diffused Junction. *IEEE J. of Lightwave Tech.,* February 1992, vol. 10 (2), 182-193

- **TAROF et al.** Planar InP-InGaAs Single-Growth Avalanche Photodiodes with No Guard Rings. *IEEE Photonics Technology Letters,* November 1995, vol. 7 (11), 1330-1132